(19) Europäisches Patentamt

European Patent Office

Office européen des brevets

(11) EP 0 446 439 B1

(12) **EUROPÄISCHE PATENTSCHRIFT**

(45) Veröffentlichungstag und Bekanntmachung des Hinweises auf die Patenterteilung:
**24.07.1996 Patentblatt 1996/30**

(51) Int Cl.⁶: **H01L 31/111**, H01L 31/0352

(21) Anmeldenummer: **90123239.7**

(22) Anmeldetag: **04.12.1990**

(54) **Thyristor mit reflexionsarmer Lichtzündstruktur**

Thyristor having a light ignition structure with low reflection

Thyristor comprenant une structure d'allumage par la lumière avec faible réflexion

(84) Benannte Vertragsstaaten:
**CH DE GB LI SE**

(30) Priorität: **12.03.1990 DE 4007817**

(43) Veröffentlichungstag der Anmeldung:
**18.09.1991 Patentblatt 1991/38**

(73) Patentinhaber: **SIEMENS AKTIENGESELLSCHAFT**
**80333 München (DE)**

(72) Erfinder:
• **Türkes, Peter, Dr.**
**W-8025 Unterhaching (DE)**

• **Kuhnert, Reinhold, Dr.**
**W-8000 München 19 (DE)**

(56) Entgegenhaltungen:
**EP-A- 0 173 275        DE-A- 2 408 079**

• **PATENT ABSTRACTS OF JAPAN vol. 6, no. 32 (E-96)(910) 26 Februar 1982 ; & JP-A-56 152 266**
• **PATENT ABSTRACTS OF JAPAN vol. 2, no. 145 (E-78)(9147) 04 Dezember 1978 ; & JP-A-53 112 682**
• **APPLIED PHYSICS LETTERS, vol. 55, no. 13, 25 September 1989, New York US, Seiten 1363-1365; A.W. BLAKERS et al.: "22.8% efficient solar cell"**

EP 0 446 439 B1

## Beschreibung

Die Erfindung bezieht sich auf einen Thyristor mit reflexionsarmer Lichtzündstruktur nach dem Oberbegriff des Patentanspruchs 1.

Ein Thyristor dieser Art ist aus der Veröffentlichung mit dem Titel "Novel Gate Structure for High Voltage Light-Triggered Thyristor" aus dem Japanese Journal of Applied Physics, Volume 21 (1982) Supplement 21-1, pp. 91- 96, bekannt. Dabei wird zur Reflexionsverminderung eine $\lambda/4$-Schicht aus Siliziumoxid aufgebracht, dies hat jedoch den Nachteil, daß der Reflexionsgrad relativ stark von der Wellenlänge $\lambda$ abhängt und eine zusätzliche Anzahl von Herstellungsprozeßschritten erforderlich ist.

Aus dem Applied Physics Letters, Vol. 55, No. 13, 25. September 1989, Seiten 1363 bis 1365 ist bekannt, daß bei Silizium-Solarzellen der Reflexionsgrad der Oberfläche, durch anisotropes Ätzen von pyramidenförmigen Vertiefungen gesenkt werden kann.

Der Erfindung liegt die Aufgabe zugrunde, einen Thyristor der eingangs genannten Art anzugeben, dessen reflexionsarme Lichtzündstruktur mit einer möglichst geringen Zahl zusätzlicher Prozeßschritte hergestellt werden kann. Das wird erfindungsgemäß durch eine Ausbildung nach dem kennzeichnenden Teil des Patentanspruchs 1 erreicht.

Der mit der Erfindung erzieltbare Vorteil liegt insbesondere darin, daß durch die nach der Erfindung ausgebildete reflexionsarme Lichtzündstruktur gleichzeitig auch zum Einstellen einer definierten Überkopfzündspannung benutzt wird.

Die Patentansprüche 2 und 3 sind auf bevorzugte Verfahren zur Herstellung der erfindungsgemäßen Lichtzündstruktur gerichtet.

Die Erfindung wird nachfolgend anhand der Zeichnung näher erläutert. Dabei zeigt:

Figur 1    ein dreidimensional und im Halbschnitt dargestellter, nach der Erfindung ausgebildeter Thyristor mit reflexionsarmer Lichtzündstruktur,

Figur 2    eine im Schnitt dargestellte Vergrößerung eines Teiles der Photoneneintrittsfläche des in Figur 1 dargestellten Thyristors mit zugehörigen Strahlenverläufen.

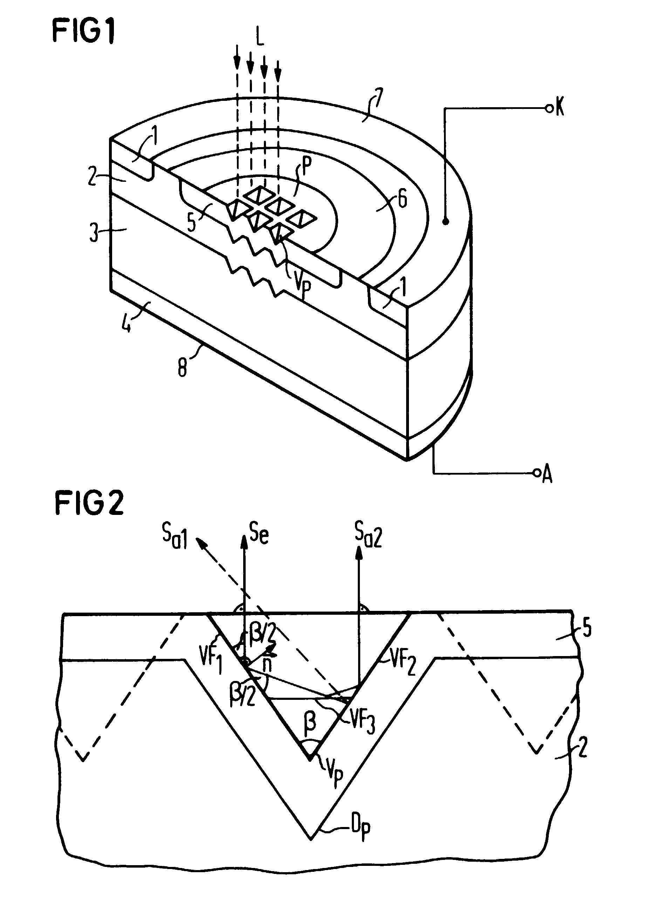

Figur 1 zeigt einen erfindungsgemäß ausgebildeten Thyristor mit reflexionsarmer Lichtzündstruktur bestehend aus vier Halbleiterschichten alternierenden Leitungstyps, wobei die erste Schicht mit der Anodenelektrode AE und der Anodeklemme A elektrisch leitfähig verbunden ist und die p-Emitterschicht 4 darstellt, auf die der Reihe nach, die n-Basisschicht 3, die p-Basisschicht 2 und die $n^+$-dotierte Schicht für n-Emitter 1 und Hilfsemitter 5 folgen, wobei diese $n^+$-Schicht den Thyristor auch im Bereich unmittelbar unterhalb der Photonen eintrittsfläche P ausfüllt. Der n-Emitter ist elektrisch leitend mit der Kathodenelektrode 7 und der Kathodenklemme K verbunden, darüber hinaus besteht stirnseitig eine elektrisch leitende Verbindung 6 zwischen der p-Basis 2 und dem $n^+$-dotierten Gebiet 5 direkt unterhalb der Photoneneintrittsfläche P im Bereich des Hilfsemitters. Die Photoneneintrittsfläche P weist die nach der Erfindung ausgebildeten pyramidenförmigen Vertiefungen $V_p$ auf, in die das Licht L einfällt. Die Dotierungsgrenzfläche zwischen den Schichten 2 und 5 und die Dotierungsgrenzfläche zwischen den Schichten 3 und 2 folgen im Bereich der Photoneneintrittsfläche P der Kontur der mit den Vertiefungen versehenen Thyristoroberfläche, falls die Dotierung der Schichten 2 und 5 erst nach dem Einbringen der Vertiefung erfolgt. Durch entsprechend den Vertiefungen ausgebildete Dotierungsgrenzflächen stellt sich eine fest definierte Überkopfzündspannung ein.

Fällt nun Licht L auf die Photoneneintrittsfläche, so werden einige auftreffende Photonen reflektiert, die meisten dringen aber ins Innere des Thyristors, wo sie aufgrund des Photoeffekts Elektron-Lochpaare erzeugen, falls ihre Energie größer als der Bandabstand des Halbleitermaterials ist. Im Bereich der p-Basis 2 und der n-Basis 3 erfolgt, aufgrund der angelegten Spannung, eine Trennung der so entstandenen Löcher und Elektronen in der Weise, daß die Löcher in die p-Basis 2 und die Elektronen in die n-Basis 3 wandern und somit einen Basisstrom darstellen. Durch Verstärkungs- und Rückkopplungseffekte bewirkt der Basisstrom ein lawinenartiges Ansteigen des Anodenstromes und ein Zünden des Thyristors.

Um das Zünden des Thyristors zu ermöglichen muß eine Mindestzahl von Photonen genügend hoher Energie in den Thyristor gelangen deshalb ist ein Minimum an Reflexion im Bereich der Photoneneintriffsfläche P anzustreben. Nach der Erfindung wird dies durch die in Figur 1 dargestellten pyramidenförmigen Vertiefungen $V_P$ im Bereich der Photoneneintrittsfläche P erreicht.

Die Reflexionsverminderung besteht dadurch, daß die einfallenden Photonen mehrmals auf eine Grenzfläche zwischen Halbleitermaterial und das es umgebende Medium treffen, dabei wird jeweils ein Teil der Photonen absorbiert und ein Teil reflektiert. Für eine einfache Abschätzung der Photonenabsorption kann senkrechte Inzidenz von unpolarisiertem Licht angenommen werden. Der nach einer Reflexion reflektierte Anteil R hängt von der Brechzahl n ab, dabei gilt

$$R = ((n - 1)/(n + 1))^2.$$

Erfolgt eine k-fache Reflexion, so wird bei der letzten Reflexion nur noch ein Anteil $R^k$ reflektiert. Für die Gesamtabsorption nach k Reflexionen gilt dann

$$A_k = 1 - R^k.$$

Für Silizium ist die Brechzahl ungefähr n = 3,6, damit wird bei einer Reflexion $A_1 = 68$ Prozent, bei zwei Reflexionen $A_2 = 90$ Prozent und bei drei Reflexionen

$A_3 = 97$ Prozent der eingestrahlten Photonen absorbiert.

Zur Verdeutlichung wird in Figur 2 eine Vergrößerung eines Teils der erfindungsgemäß gestalteten Photoneneintrittsfläche dargestellt, wobei ein einfallender Strahl $S_e$ an den zwei Vertiefungsflächen $VF_1$, $VF_2$ reflektiert wird bevor er die Vertiefung $V_P$ als Strahl $S_{a1}$ austritt oder an den drei Vertiefungsflächen $VF_1$, $VF_2$ und $VF_3$ reflektiert wird bevor der als Strahl $S_{a2}$ austritt. Nur wenn die durch den einfallenden Strahl Se und den Normalenvektor n der ersten Reflexionsfläche aufgespannte Ebene durch den Pyramidenscheitel geht, tritt eine Reflexion an zwei Flächen auf. Sonst erfolgen die Reflexionen über drei der vier Vertiefungsflächen, wobei die Schnittgerade, die durch die vom Normalenvektor und dem einfallenden Strahl aufgespannte Ebene und der dritten Vertiefungsfläche $VF_3$ gebildet wird, repräsentativ für die gesamte dritte Vertiefungsfläche in Figur 2 eingezeichnet und mit $VF_3$ bezeichnet ist. Der Absorptionsgrad der pyramidenförmigen Vertiefung $V_P$ wird daher nur etwas weniger als 97 Prozent betragen. Unterhalb der pyramidenförmigen Vertiefung $V_P$ ist in Figur 2 ebenfalls die Dotierungsgrenzfläche $D_P$ als Trennfläche der Dotierungsgebiete 2 und 5 dargestellt.

Die pyramidenförmigen Vertiefungen in der Photoneneintrittsfläche P des Thyristors können durch ein bevorzugtes Herstellungsverfahren einfach erzeugt werden, indem ein {100}-Si-Wafer verwendet wird, auf dem eine Maske mit quadratischen Öffnungen so ausgerichtet ist, daß jeweils eine Kante der Maskenöffnung parallel zur<100>-Richtung des {100}-Si-Wafers ist und anisotrop geätzt wird. Der Spitzenwinkel β wird in diesem Fall, wie in Figur 2 dargestellt, ungefähr gleich 70° und ist alleine durch die kristallographischen Parameter bestimmt. Die quadratischen Maskenöffnungen haben in diesem Fall zum Beispiel eine Kantenlänge von ca. 60 μm und sind durch schmale Stege getrennt. Die Scheitelhöhe der Pyramide beträgt dann ca. 40 μm, was ein Mehrfaches der Dicke der n+-Schicht 5 und etwa die Hälfte p-Schicht 2 darstellt.

## Patentansprüche

1. Thyristor mit reflexionsarmer Lichtzündstruktur, mit einer Folge von Halbleiterschichten alternierender Leitungstypen, die einen von einer anodenseitigen Elektrode (8) kontaktierten p-Emitter (4), eine n-Basis (3), eine p-Basis (2) und eine n+-Schicht für die Ausnehmungen des kathodenseitig kontaktierten n-Emitters (1) und des Hilfsemitters oder des Floating-Gate-Bereichs (5) umfassen, wobei letzterer eine reflexionsarme Photoneneintrittsfläche (P) aufweist,

   **dadurch gekennzeichnet**,
   daß die reflexionsarme Photoneneintrittsfläche (P) durch pyramidenförmige Vertiefungen ($V_P$) an der Photoneneintrittsfläche (P) gebildet wird, wobei der Reflexionsgrad weitgehend wellenlängenunabhängig ist, und daß die Dotierungsgrenzfläche zwischen der p-Basis (2) und der n-Basis (3) sowie die Dotierungsgrenzfläche der p-Basis (2) und des Floating-Gate-Bereichs (5) der Oberflächenkontur der Photoneneintrittsfläche (P) folgen.

2. Verfahren zur Herstellung eines Thyristors nach Anspruch 1,

   **dadurch gekennzeichnet**,
   daß die pyramidenförmigen Vertiefungen ($V_P$) in der Photoneneintrittsfläche (P) bereits vor der Dotierung der p-Basis (2) und des Floating-Gate-Bereiches (5) gebildet werden.

3. Verfahren nach Anspruch 2,

   **dadurch gekennzeichnet**,
   daß die pyramidenförmigen Vertiefungen ($V_P$) durch anisotropes Ätzen eines {100}-Wafers gebildet wird, wobei der {100}-Wafer vor dem Ätzen durch eine Ätzmaske mit relativ zum Kristallgitter in <100>-Richtung ausgerichteten quadratischen Maskenöffnungen abgedeckt ist.

## Claims

1. Thyristor having a low-reflection light-triggering structure, having a sequence of semiconductor layers of alternating conduction types which comprise a p-type emitter (4), which is made contact with by an anode-side electrode (8), an n-type base (3), a p-type base (2) and an n+-type layer for the recesses of the n-type emitter (1), which is made contact with on the cathode side, and of the auxiliary emitter or of the floating gate region (5), the latter having a low-reflection photon entry face (P), characterized in that the low-reflection photon entry face (P) is formed by pyramidal depressions ($V_P$) at the photon entry face (P), the degree of reflection being largely independent of the wavelength, and in that the doping boundary between the p-type base (2) and the n-type base (3) and the doping boundary between the p-type base (2) and the floating gate region (5) follow the surface contour of the photon entry face (P).

2. Method for the production of a thyristor according to Claim 1, characterized in that the pyramidal depressions ($V_P$) in the photon entry face (P) are already formed prior to the doping of the p-type base (2) and of the floating gate region (5).

3. Method according to Claim 2, characterized in that the pyramidal depressions (V_P) are formed by anisotropic etching of a {100} wafer, the {100} wafer being covered prior to etching by an etching mask having square mask openings aligned in the <100> direction relative to the crystal lattice.

## Revendications

1. Thyristor ayant une structure d'amorçage par de la lumière, cette structure réfléchissant peu, le thyristor comportant une succession de couches de semiconducteur, qui ont des types de conductivité alternant, qui comprennent un émetteur p (4) en contact avec une électrode (8) côté anode, une base n (3), une base p (2) et une couche $n^+$ pour les évidements de l'émetteur n (1) mis en contact du côté cathode et de l'émetteur auxiliaire ou de la zone (5) de grille flottante, cette zone (5) de grille flottante comportant une surface (P) d'introduction de photons, qui réfléchit peu,

   caractérisé en ce que
   la surface (P) d'introduction de photons qui réfléchit peu est formée de renfoncements (V_P) pyramidaux de la surface (P) d'introduction de photons, le facteur de réflexion étant dans une large mesure indépendant de la longueur d'ondes, et la surface limite de dopage entre la base p (2) et la base n (3) ainsi que la surface limite de dopage de la base p (2) et de la zone (5) de grille flottante suivent le contour de la surface (P) d'introduction de photons.

2. Procédé de fabrication d'un thyristor suivant la revendication 1,

   caractérisé en ce que
   on forme déjà les renfoncements pyramidaux (V_P) dans la surface (P) d'introduction de photons avant de doper la base p (2) et la zone (5) de grille flottante.

3. Procédé suivant la revendication 2,

   caractérisé en ce que
   on forme les renfoncements (V_P) pyramidaux par attaque chimique anisotrope d'une tranche {100}, la tranche {100} étant recouverte, avant l'attaque chimique, d'un masque d'attaque chimique ayant des ouvertures de masque carrées orientées dans la direction <100> par rapport au réseau cristallin.

## FIG1

## FIG2